# EUROPEAN PATENT SPECIFICATION

(11) **EP 1 927 940 B1**
(45) Date of publication and mention of the grant of the patent: **24.06.2015**
(21) Application number: 06024978.6
(22) Date of filing: 02.12.2006
(51) Int. Cl.: H05K 1/03, G06K 19/077

(54) **Functional laminate**
Funktionelles Laminat
Substrat fonctionnel

(43) Date of publication of application: 04.06.2008
(73) Proprietor: HID Global GmbH, 65396 Walluf (DE)
(72) Inventor: Michalk, Manfred, 99092 Erfurt (DE); Hirschfeld, Kay, 99195 Stotternheim (DE)
(74) Representative: Grosfillier, Philippe

(56) References cited:
- EP-A- 0 913 268
- EP-A- 1 361 538
- FR-A- 2 826 154

## Description

### Field of the Invention

The invention refers to functional laminates, particularly for use as flexible wiring, e.g. in smart clothing or as substrates for chip modules.

Such functional laminates have to be very flexible and resistant to environmental stress like extreme temperatures, pressure and humidity. When chip modules are embedded in the functional laminate, they have to be well protected. Contactless information carriers such as contactless ID cards have conquered the market over the past years. Contactless ID cards are produced on large scale by using multi-layer lamination technique. Such a technique is described in DE 43 37 921 A1, where a card inlet is produced in a first lamination step. Cover or protection sheets are then added during a second lamination step. This two step process, with inlet production first, has been widely extended to the manufacture of all kinds of transponder products. The primary function of the inlet packaging is to protect and keep together the active elements of the transponder, such as a chip module and an antenna coil connected with each other. Inlets are for example produced by arranging the transponder, comprising an IC chip and an antenna coil connected with each other, on a first plastic foil, covering it with a second plastic foil, and hot laminating all together. Typically, PVC or identical material is used as foil material. Alternatively, transponders can even be delivered arranged on the first foil substrate, without any laminated coverage layer.

By reducing the amount of substrate material use or using smoother plastic such as polyurethane (PU) thicker or more flexible functional laminates can be produced but their resistance and solidity decrease at the same time.

EP 0 913 268 A1 describes a flexible IC module comprising a flexible substrate having compressibility in the thickness direction, self-pressure-bonding property and resin impregnation property and a mounted part supported by said flexible substrate, said part being embedded in a dent formed by compression in a portion of the flexible substrate, whereby the flexible substrate can be a non-woven fabric.
Known functional laminates are either too stiff or too thick or tend to delaminate under mechanical stress like bending.

EP 1 361 538 shows a transponder whereby the carrier is a paper with a grammage of 20-400 g/m²

### Summary of the invention

It is accordingly an object of the present invention to provide an improved functional laminate.

With that object in view, the present invention suggests a functional laminate, comprising at least one electrically conductive component, particularly an antenna coil or a track, arranged on a porous non-woven substrate with a grammage of less than 10 g/m². Non-woven means textiles, whose fibres are neither knit nor woven. Instead fibres are put together in the form of a sheet or web and bound to each other mechanically (at least by inter-fibre friction), thermally or by means of an adhesive. It was a surprise to find that such a thin and porous (almost evanescent) non-woven could be an adequate substrate to fix an antenna or another electrically conductive component. It was not self-evident that a light non-woven would be strong enough to support the antenna and could have enough strength to keep its conductive pads in position.

Preferably, the non-woven substrate is waterproof or even boil-proof, so the functional laminate can be washed when used in smart clothing or the like.

In a preferred embodiment of the invention the non-woven substrate contains long and natural fibres with less than 25 micrometers in diameter. Particularly the fibres length is at least two to three times the thickness of the conductive component, most preferable 2 mm to 10 mm. Thus the non-woven gets better mechanical strength due to improved inter-fibre friction and forms a cobweb-like structure to support the conductive component and to hold it in a defined position at least temporarily.

In one preferred embodiment of the invention the conductive component is a wire. Wires are easily bendable and available at low cost. Alternatively the conductive component can have the form of a flat metal stripe. The wire can be fixed on the non-woven substrate by different techniques of the art, as for example the wire transfer technique described in EP1352551 or the wire embedding technique described in EP08800754.

In a preferred embodiment the wire is enamelled with a thermosetting varnish, through which the wire is fixed to the non-woven substrate in order to assure a better fixation of the wire on the non-woven substrate. When fixing the wire to the non-woven substrate the thermosetting varnish is activated by heat and/or pressure, so it partially penetrates the non-woven substrate and congeals when cooling off. An alternative could be to cover the non-woven foil with a thin thermosetting adhesive layer for example.

In a particularly preferred embodiment a second non-woven substrate is arranged over the conductive component. A space between the two non-woven substrates is filled with a filling material, particularly a plastic material, e.g. Polyurethane (PU) or a hot-melt adhesive. The second non-woven substrate can have the same material properties like the first one described above. Preferably, the three layers are laminated together with the conductive component inside. The result is a planar laminate structure with the non-woven substrate at least partially penetrated by the filling material. As the non-woven substrates are very thin and porous, the filling material can easily penetrate them, making the lamination much easier. A surprising advantage is that the smooth filling material is strongly reinforced by the very thin non-woven substrates. The resulting functional laminate can absorb stresses and shearing force. It is resistive to plastic deformation and returns to its initial form after being bend. Very surprising is that, due to the non-woven foils, shrinking of the filling material during and after the lamination almost disappears, even at higher temperatures. This allows the lamination to be carried out at high temperatures near the weakening point of the filling material, so the filling material is soft enough to flow around the conductive component and thus mechanical stress is avoided for the conductive component. Moreover, curling or other deformations of the functional laminate's geometry are avoided. Natural fibres, e.g. made from the banana plant, are favoured over synthetic fibres for the non-woven substrate because they better catenate with PU as a filling material. The filling material can be alternatively applied in liquid form to the first non-woven substrate

The presence of non-woven substrates on the external sides of the functional laminate facilitates the adhesion (by lamination for example) of extra encapsulation material. In such a case, the non-woven substrate will reinforce the lamination interface, as it will be easily fully penetrated by the encapsulation materials. The encapsulation material is preferably the same as the filling material, so both have the same material properties, e.g. the expansion coefficient, and thus twisting is avoided. The resulting laminate is flexible, easy to manufacture, robust and reliable. Such a functional laminate can be used as is, e.g. as a label for identifying goods or for special functions inside smart clothing or as a semifinished product, e.g. as an inlet for an ID card or the like.

Preferably the distance between the two non-woven substrates corresponds approximately to the thickness of the conductive component. The non-woven substrates hardly add much to the thickness of the conductive component so the overall thickness of the functional laminate is basically determined by the thickness of the conductive component, so a minimum of space is required while a maximum of flexibility and mechanical strength is achieved. Such a functional laminate is easy to fix on/in a multitude of products, e.g. by sewing. It is extremely flexible, resistant to environmental stresses, can be washed, boiled, ironed, bend or even crumpled (screwed up) without damage.

In a further embodiment of the invention a recess is extending at least partially through at least one of the two non-woven substrates and/or the filling material, so a chip module can be inserted. A functional laminate with such a chip module can be a transponder, for instance. In this case at least one of the conductive components serves as an antenna connected to the chip module, which implements RFID functionalities.

The conductive component or antenna is preferably electrically connected to the chip module by bonding portions of the conductive component on contact pads of the chip module. Bonding particularly refers to a welding technique, which is one of the easiest, reliable and low-cost techniques for electrically connecting metallic components.

In a preferable embodiment of the invention, at least one of the non-woven substrates is at least partially disrupted in the region around the bonded portion of the conductive component. The bonding process can imply the use of high pressure and temperature, as for example through thermo compression bonding. In such case, the part of the non-woven substrate in proximity of the bonding area would not resist the heat due to the bonding process and would be at least partially destructed. This is prevented by a disruption of the non-woven substrate in this region.

### Detailed description of the invention

A functional laminate will now be described in detail with reference to the accompanying drawing, in which:
Figure 1 shows two different conductive components fixed on a non-woven substrate,
Figure 2 shows the fixing of two conductive components to the non-woven substrate,
Figure 3 shows the bonding of the conductive component from figure 2 on contact pads of a chip module,
Figure 4 shows a functional laminate with two non-woven substrates, a filling material and two conductive components,
Figure 5 shows a functional laminate with a chip module used as a transponder,
Figure 6 shows the functional laminate from figure 5 with an encapsulation.

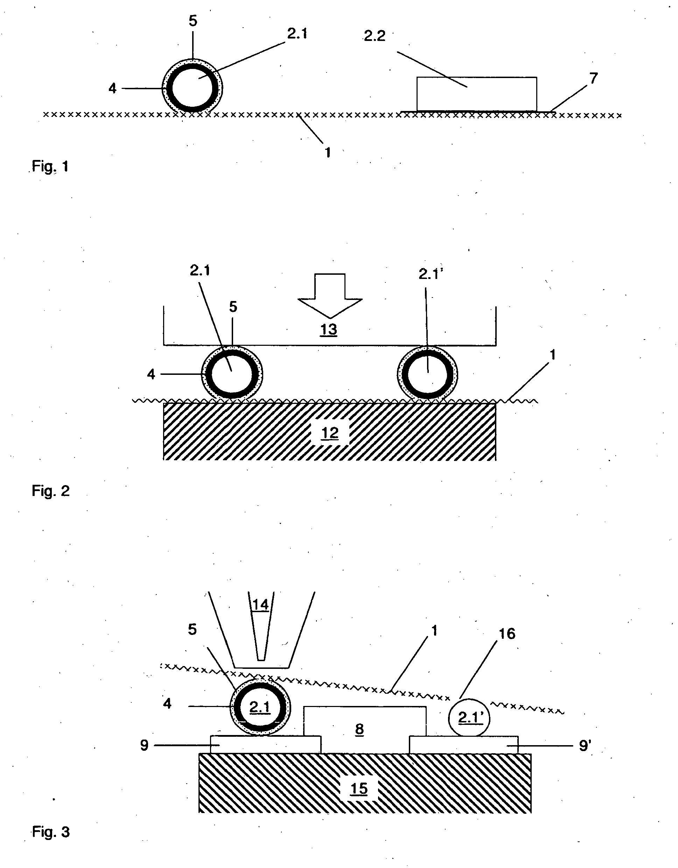

**Figure 1** shows a non-woven substrate 1 with two different conductive components 2.1, 2.2 attached to it. On the left, the conductive component 2.1 is formed as a wire, preferably a copper wire. This wire is enamelled successively with an insulating layer 4, and a thermosetting varnish 5. The thermosetting varnish 5 is partially penetrating the non-woven substrate 1, thus fixing the position of the conductive component 2 on the non-woven substrate 1. On the right, the conductive component 2.2 is formed as a conductive track, preferably punched out from a copper foil for example. The conductive component 2.2 is fixed on the non-woven substrate 1 by means of an adhesive layer 7, that has been previously impregnated on the surface of the non-woven substrate 1.

The non-woven substrate 1 is very thin compared to the conductive component 2.1, 2.2. It is made of fibres, put together in the form of a sheet and bonded, either mechanically, by thermal bonding, by chemical bonding (binder, adhesive), by hydro-entanglement, by needlefelt, etc. The non-woven substrate 1 is very thin and very porous and made of long fibres and if necessary small quantities of bonding material. Preferably, the non-woven substrate 1 has a grammage of less than 10 g/m². Furthermore it is waterproof, boil-proof and can be ironed.

For example the non-woven substrate 1 can be composed ofDynatec 8,5/LCM of Papierfabrik Schoeller & Hoesch GmbH & Co. It shows a grammage of 8,5 g/m² and a thickness (calliper) of 35 micrometers. It is made of fibres with a diameter of less than 25 micrometers diameter.

**Figure 2** shows a method for fixing conductive components 2.1, 2.1' to a non-woven substrate 1. The non-woven substrate 1 is placed over a heated surface of an oven 12. A stamp 13 presses the conductive component 2.1, 2.1' on the non-woven substrate 1. When the part of the thermosetting varnish 5, which is in contact with the non-woven substrate 1 is reaching its melting point, it penetrates into the pores of the non-woven substrate 1. Once cured, this ensures a very good fixation of the conductive component 2.1, 2.1' on the non-woven substrate 1. The temperature of the oven 12 has to be high enough to allow a fast intrusion of the thermosetting varnish 5 but without damaging the non-woven substrate 1. When using Backlackdraht B155, a typical off-the-shelf wire for the conductive component 2.1, 2.1', a temperature of 225°C appears to be appropriate. The conductive components 2.1, 2.1' depicted can be actually parts of the same conductive component run in a loop or in switchbacks. The pressure applied to the conductive components 2.1, 2.1' can lead to minor deformations thereof.

**Figure 3** illustrates a way to connect the conductive components 2.1, 2.1' already fixed to the non-woven substrate 1 (see figure 2) to a chip module 8. The chip module 8, having two contact pads 9 and 9', is placed on an anvil 15. The non-woven substrate 1 is placed over the chip module 8 in such a way that the conductive components 2.1 and 2.1' are laying directly on the two contact pads 9 and 9'. In the example illustrated, the conductive component 2.1 is going to be bonded to the contact pad 9 by means of a thermo-compression head 14. The conductive component 2.1' has already been welded with the contact pad 9'. Due to the high pressure and temperature involved, the insulating layer 4 and thermosetting varnish 5 of the conductive component 2.1' have disappeared locally in the contact area. The temperature can also lead to local disruptions 16 of the non-woven substrate 1. The fixation of the conductive component 2.1, 2.1' and thus indirectly of the chip module 8 on the non-woven substrate 1 is ensured by all the rest of the conductive component 2.1, 2.1' not having been subjected to the bonding process.

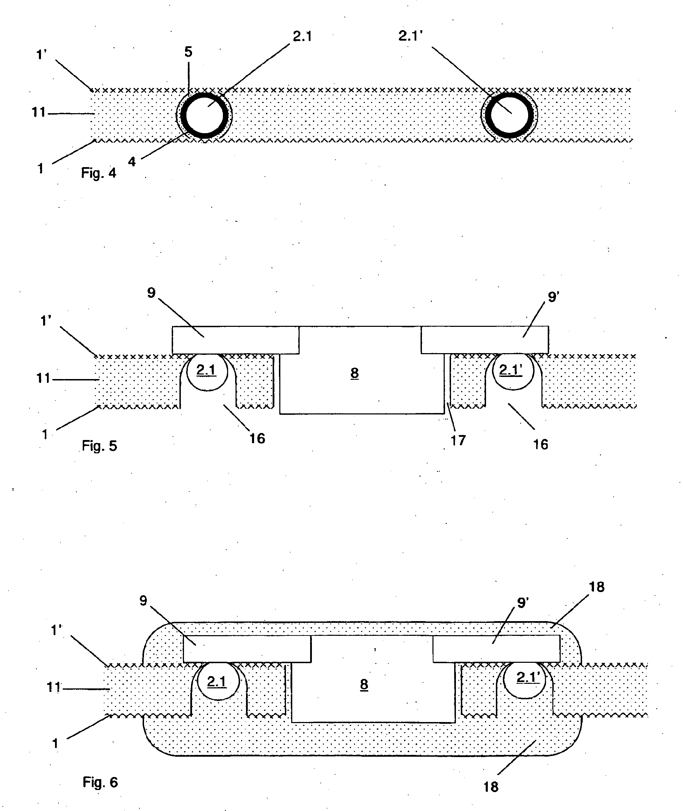

**Figure 4** shows a functional laminate 6. As in figure 2, the conductive components 2.1, 2.1' are fixed to the non-woven substrate 1. A second non-woven substrate 1' is additionally arranged over the conductive components 2.1, 2.1' with a filling material 11 filling the space around the conductive components 2.1, 2.1' between the two non-woven substrates 1 and 1'. The filling material 11 can be a hot-melt adhesive or a smooth plastic material as PU, TPU, PE, PVC (smooth). One possible method for producing this functional laminate 6 includes the following steps:
- fixing the conductive components 2.1, 2.1' on the non-woven substrate 1 (see figure 2)
- arranging the filling material 11 and a second non-woven substrate 1' over the conductive components 2.1, 2.1' in order to form a pre-lamination structure
- laminating the pre-laminating structure

The result is a planar functional laminate 6 with the non-woven substrates 1, 1' at least partially embedded in the filling material 11. As the non-woven substrates are very thin and porous, the filling material 11 can easily penetrate them, making the lamination much easier. As no shrinking of the functional laminate 6 appears during lamination, the temperature can be relatively high so the laminating pressure can be kept low enough to avoid mechanical stress to the chip module 8, in case the chip module 8 is laminated together with the non-woven substrates 1, 1' and the filling material, which is an alternative method of manufacturing a functional laminate 6. Example lamination parameters for PU as filling material 11 are a temperature of 180 °C to 205 °C and a pressure of 20 N/cm² to 60 N/cm².

**Figure 5** illustrates a way to manufacture a functional laminate 6 in the form of a transponder basing on the functional laminate 6 from figure 4. Firstly, a recess 17 is formed through the functional laminate 6 in an area between the conductive components 2.1, 2.1' being part of an antenna. Depending on the size of the chip module 8, the recess 17 extends partially or totally through the two non-woven substrates 1,1' and the filling material 11. Then, the chip module 8 is placed in the recess 17, such that the contact pads 9, 9' are laying over portions of the conductive components 2.1, 2.1'. A bonding process identical to that illustrated in figure 3 is applied then. The non-woven substrate 1, 1' and the filling material 11 can be locally destructed resulting in small disruptions 16 around the bonded parts of the conductive components 2.1, 2.1'.

Figure 6 shows the functional laminate 6 from figure 5 with an encapsulation material 18 applied. The encapsulation material 18 has been applied on both sides of the functional laminate 6 in order to fill the disruptions 16 and the recess 17 and to fully embed and protect the chip module 18. Preferably, the encapsulation material 18 is the same as the filling material 11. The transponder resulting is very thin (basically as thin as the conductive components 2.1, 2.1'), extremely flexible, shows no shrinking, can be easily fixed on any kind of substrates/products, is resistant to mechanical and environmental stresses, can be bend, crumpled and even washed, boiled or ironed without damages. Naturally it can be used as is, or as an inlet, embedded in a larger lamination structure like a contactless chip card for example.

Although the invention has been shown and described with respect to certain preferred embodiments, it is obvious that equivalent alterations and modifications may be envisaged by others skilled in the art upon the reading and the understanding of this specification and the annexed drawings.

The range of applications covered by the invention is not restricted to contactless cards. Functional laminates 6 in the form of transponders can be used for marking laundry and other textiles, for example or they can be embedded in other structures like a ski, where they have to resist enormous environmental stresses (pressure, torsion, extreme temperatures (from minus 50 °C to +80 °C)). In this case the filling material 11 is preferably the same as the material of the structure, the functional laminate 6 is embedded in. Functional laminates 6 in general can also serve as flexible wiring.

### List of references :

- 1, 1': non-woven substrate
- 2.1, 2.1', 2.2: conductive component
- 4: insulating layer
- 5: thermosetting varnish
- 6: functional laminate
- 7: adhesive layer
- 8: chip module
- 9, 9': contact pads
- 11: filling material
- 12: oven
- 13: stamp
- 14: thermo-compression head
- 15: anvil
- 16: disruption
- 17: recess
- 18: encapsulation material

## Claims

1. Functional laminate (6), comprising at least one electrically conductive component (2.1, 2.1', 2.2), particularly an antenna coil or a track, arranged on a porous non-woven substrate (1) **characterised in that** the porous non-woven substrate has a grammage of less than 10g/m².

2. Functional laminate (6) according to claim 1, **characterized in that** the non-woven substrate (1) is waterproof.

3. Functional laminate (6) according to one of the claims 1 or 2, **characterized in that** the non-woven substrate (1) contains long natural fibres with less than 25 micrometers in diameter.

4. Functional laminate (6) according to one of the claims 1 to 3, **characterized in that** the conductive component (2.1, 2.1') is a wire.

5. Functional laminate (6) according to claim 4, **characterized in that** the wire is enamelled with a thermosetting varnish (5), through which the wire is fixed to the non-woven substrate (1).

6. Functional laminate (6) according to one of the preceding claims, wherein a second non-woven substrate (1') is arranged over the conductive component (2.1, 2.1', 2.2), and wherein a space between the two non-woven substrates (1, 1') is filled with a filling material (11), particularly a plastic material or a hot-melt adhesive.

7. Functional laminate (6) according to claim 6, wherein the distance between the two non-woven substrates (1, 1') corresponds approximately to the thickness of the conductive component (2.1, 2.1', 2.2).

8. Functional laminate (6) according to one of the claims 6 to 7, wherein a recess (17) for accommodating a chip module (8) is extending at least partially through at least one of the two non-woven substrates (1, 1') and/or the filling material (11).

9. Transponder with a chip module (8) arranged in a functional laminate (6) according to one of the preceding claims, wherein the conductive component (2.1, 2.1', 2.2) formed as an antenna coil is electrically connected to the chip module (8) by bonding portions of the conductive component (2.1, 2.1', 2.2) on contact pads (9, 9') of the chip module (8).

10. Transponder according to claim 9, wherein at least one of the non woven substrates (1, 1') is at least partially disrupted in the region around the bonded portion of the conductive component (2.1, 2.1', 2.2).

## Patentansprüche

1. Funktionales Laminat (6), mindestens eine elektrisch leitfähige Komponente (2.1, 2.1', 2.2) umfassend, insbesondere eine Antennenspule oder eine Bahn, die auf einem porösen Vliessubstrat (1) angeordnet ist, **dadurch gekennzeichnet, dass** das poröse Vliesmaterial ein Flächengewicht von weniger als 10 g/m² aufweist.

2. Funktionales Laminat (6) nach Anspruch 1, **dadurch gekennzeichnet, dass** das Vliessubstrat (1) wasserdicht ist.

3. Funktionales Laminat (6) nach einem der Ansprüche 1 bis 2, **dadurch gekennzeichnet, dass** das Vliessubstrat (1) lange Naturfasern mit weniger als 25 µm Durchmesser enthält.

4. Funktionales Laminat (6) nach einem der Ansprüche 1 bis 3, **dadurch gekennzeichnet, dass** die leitfähige Komponente (2.1, 2.1') ein Draht ist.

5. Funktionales Laminat (6) nach Anspruch 4, **dadurch gekennzeichnet, dass** der Draht mit einem wärmehärtenden Überzuglack (5) lackisoliert ist, wodurch der Draht am Vliessubstrat (1) befestigt ist.

6. Funktionales Laminat (6) nach einem der vorhergehenden Ansprüche, wobei über der leitfähigen Komponente (2.1, 2.1', 2.2) ein zweites Vliessubstrat (1') angeordnet ist und wobei ein Zwischenraum zwischen den zwei Vliessubstraten (1, 1') mit einem Füllmaterial (11) gefüllt ist, insbesondere mit einem Kunststoffmaterial oder einem Schmelzklebstoff.

7. Funktionales Laminat (6) nach Anspruch 6, wobei der Abstand zwischen den zwei Vliessubstraten (1, 1') etwa der Dicke der leitfähigen Komponente (2.1, 2.1', 2.2) entspricht.

8. Funktionales Laminat (6) nach einem der Ansprüche 6 bis 7, wobei sich durch zumindest eines der zwei Vliessubstrate (1, 1') und/oder des Füllmaterials (11) zumindest teilweise eine Vertiefung (17) für die Unterbringung eines Chipmoduls (8) erstreckt.

9. Transponder mit einem Chipmodul (8), in einem funktionalen Laminat (6) nach einem der vorhergehenden Ansprüche angeordnet, wobei die leitfähige Komponente (2.1, 2.1', 2.2), die als eine Antennenspule gebildet ist, elektrisch mit dem Chipmodul (8) verbunden ist, indem Abschnitte der leitfähigen Komponente (2.1, 2.1', 2.2) an Kontakt-Pads (9, 9') des Chipmoduls (8) gebondet sind.

10. Transponder nach Anspruch 9, wobei mindestens eines der Vliessubstrate (1, 1') im Bereich um den gebondeten Abschnitt der leitfähigen Komponente (2.1, 2.1', 2.2) herum zumindest teilweise unterbrochen ist.

## Revendications

1. Stratifié fonctionnel (6), comprenant au moins un composant électriquement conducteur (2.1, 2.1', 2.2), en particulier une bobine d'antenne ou une piste, disposé sur un substrat non tissé poreux (1), **caractérisé en ce que** le substrat non tissé poreux a un grammage inférieur à 10 g/m².

2. Stratifié fonctionnel (6) selon la revendication 1, **caractérisé en ce que** le substrat non tissé (1) est imperméable à l'eau.

3. Stratifié fonctionnel (6) selon une des revendications 1 à 2, **caractérisé en ce que** le substrat non tissé (1) contient de longues fibres naturelles avec moins de 25 micromètres de diamètre.

4. Stratifié fonctionnel (6) selon une des revendications 1 à 3, **caractérisé en ce que** le composant conducteur (2.1, 2.1') est un fil.

5. Stratifié fonctionnel (6) selon la revendication 4, **caractérisé en ce que** le fil est émaillé avec un vernis thermodurcissable (5), par lequel le fil est fixé au substrat non tissé (1).

6. Stratifié fonctionnel (6) selon une des revendications précédentes, dans lequel un deuxième substrat non tissé (1') est disposé sur le composant conducteur (2.1, 2.1', 2.2), et dans lequel un espace entre les deux substrats non tissés (1, 1') est rempli avec un matériau de remplissage (11), en particulier un matériau plastique ou un adhésif thermofusible.

7. Stratifié fonctionnel (6) selon la revendication 6, dans lequel la distance entre les deux substrats non tissés (1, 1') correspond approximativement à l'épaisseur du composant conducteur (2.1, 2.1', 2.2).

8. Stratifié fonctionnel (6) selon une des revendications 6 à 7, dans lequel une encoche (17) pour accueillir un module de puce (8) s'étend au moins partiellement à travers au moins un des deux substrats non tissés (1, 1') et/ou le matériau de remplissage (11).

9. Transpondeur avec un module de puce (8) disposé dans un stratifié fonctionnel (6) selon une des revendications précédentes, dans lequel le composant conducteur (2.1, 2.1', 2.2) formé comme une bobine d'antenne est relié électriquement au module de puce (8) par des parties de liaison du composant conducteur (2.1, 2.1", 2.2) sur des plots de connexion (9, 9') du module de puce (8).

10. Transpondeur selon la revendication 9, dans lequel au moins un des substrats non tissés (1, 1') est au moins partiellement interrompu dans la région autour de la partie liée du composant conducteur (2.1, 2.1', 2.2).
